# EUROPÄISCHE PATENTSCHRIFT

(11) **EP 0 319 909 B1**
(45) Veröffentlichungstag und Bekanntmachung des Hinweises auf die Patenterteilung: **01.12.1993**
(21) Anmeldenummer: 88120348.3
(22) Anmeldetag: 06.12.1988
(51) Int. Cl.: H04Q 1/02, H05K 7/18

(54) **Gestell für die elektrische Nachrichtentechnik**
Rack for electrical telecommunication
Bâti pour télécommunications électriques

(30) Priorität: 09.12.1987 DE 8716277 U
(43) Veröffentlichungstag der Anmeldung: 14.06.1989
(73) Patentinhaber: SIEMENS AKTIENGESELLSCHAFT, 80333 München (DE)
(72) Erfinder: Prechtl, Wolfgang, Ing.(grad.), D-8192 Geretsried (DE); Dörflinger, Karl, Dipl.-Ing.(FH), D-8000 München 71 (DE); Junghardt, Helmut, D-8080 Fürstenfeldbruck (DE)

(56) Entgegenhaltungen:
- DE-A- 2 833 817
- DE-A- 3 206 868
- DE-A- 3 206 908
- DE-U- 8 325 314

## Beschreibung

Die Erfindung bezieht sich auf ein Gestell für die elektrische Nachrichtentechnik bei dem in vertikaler Richtung Einzelgeräte übereinander angeordnet sind, die über Steckanschlüsse mit der Gestell- als auch der Amtsverdrahtung verbunden sind.

Bei neueren Gestellen für die Nachrichtentechnik (siehe hierzu DE-A-2 833 817) wird neben kontaktsicherer Verbindung zu den Geräten eine immer größere werdende gegenseitige und nach außen wirksame Abschirmung angestrebt. Dies ist besonders notwendig für die moderne Digitaltechnik, da dort sehr hohe Frequenzen auftreten können. die sich bis in den GHz-Bereich hinein erstrecken. So ist besonders bei hochkanaligen Anlagen bis zu 140 Mbit/s ein Schirmdämpfungsmaß von 100 dB erforderlich.

Der Erfindung liegt die Aufgabe zugrunde, ein Gestell anzugeben das diese Aufgaben mit einfachen Mitteln erfüllt.

Bei einem Gestell der eingangs genannten Art wird diese Aufgabe gemäß der Erfindung dadurch gelöst, daß der Gestellrahmen aus einer U-Profilschiene besteht, in dem rückseitig Verdrahtungsräume für Gestell- als auch Amtsleitungen vorgesehen sind und in die vorderseitig rahmenartige mit frontseitigem Deckel verschließbare Buchsen für die Geräte einsteckbar sind, und daß die Verdrahtungsräume gegenüber dem Raum für geräte gegen Hochfrequenz dicht abgeschlossen sind und daß die Leitungen zu den übereinander angeordneten Buchsen durch mittig senkrecht angeordneterechteckige Abdeckungen geführt sind und beidseits der Abdeckungen in gegenüber den Verdrahtungsräumen abgeschlossenen Räumen streifenförmige Leiterplatten, vorzugsweise Multilayerplatten angeordnet sind, auf denen sich vertikallanggestreckte Vielfachsteckverbinder befinden, neben denen mehrere Reihen von mit den einzelnen Steckkontakten verbundenen Wrapstiften liegen, die einerseits auf die durch die Abdeckung geführten Amtsleitungen und andererseits auf eine Internverdrahtung führen, die in einem Internverdrahtungsraum geführt sind und daß ferner in den Buchsen geführte Steckplatinen direkt auf die Vielfachsteckverbinder aufgesteckt sind.

Weitere vorteilhafte Ausbildungen der Erfindung sind in den Unteransprüchen dargelegt.

Nachstehend wird die Erfindung anhand von in den Figuren gezeigten Ausführungsbeispielen näher erläutert.

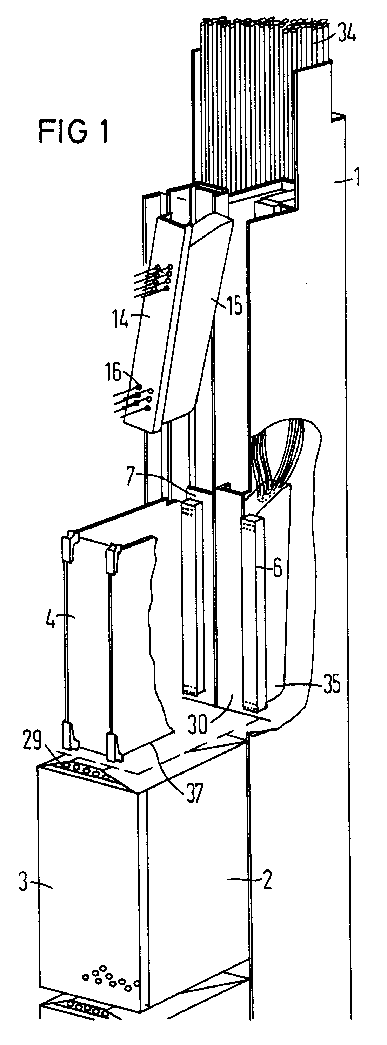

- Die Figur 1: zeigt in Perspektive den oberen Teil eines solchen Gestells.
- Die Figur 2: zeigt den unteren Teil des Gestells in der gleichen Darstellungsart.
- Die Figur 3: zeigt einen Querschnitt des Gestells in Höhe eines Einsatzes.
- Die Fgur 4: zeigt eine Draufsicht auf rückseitige Steckverbindungen für die Leiterplatten.
- Die Figuren 5 und 6: zeigen in verschiedenen Schnitten ein Zwischenelement zwischen den einzelnen buchsenförmigen Gehäusen.

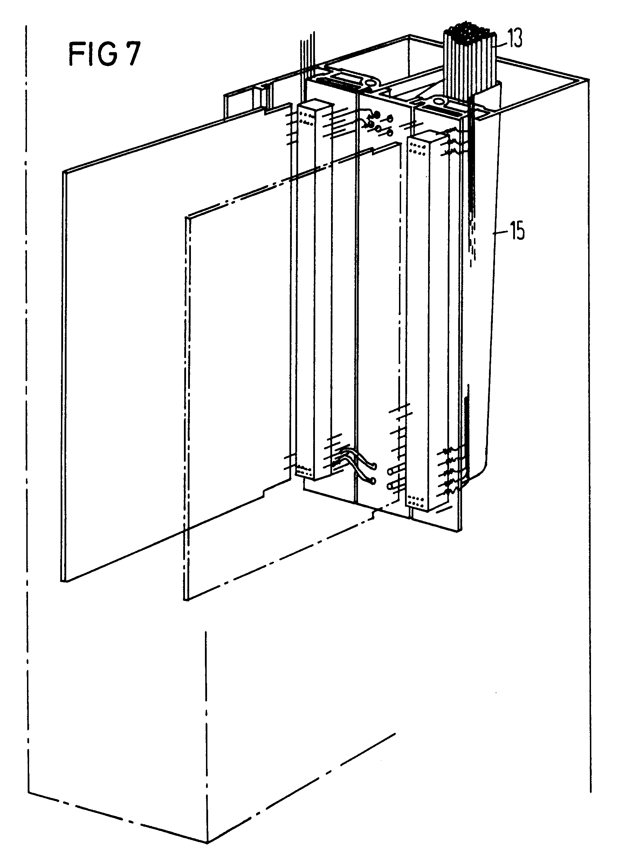

- Figur 7: zeigt Einzelheiten innerhalb einer Buchse.

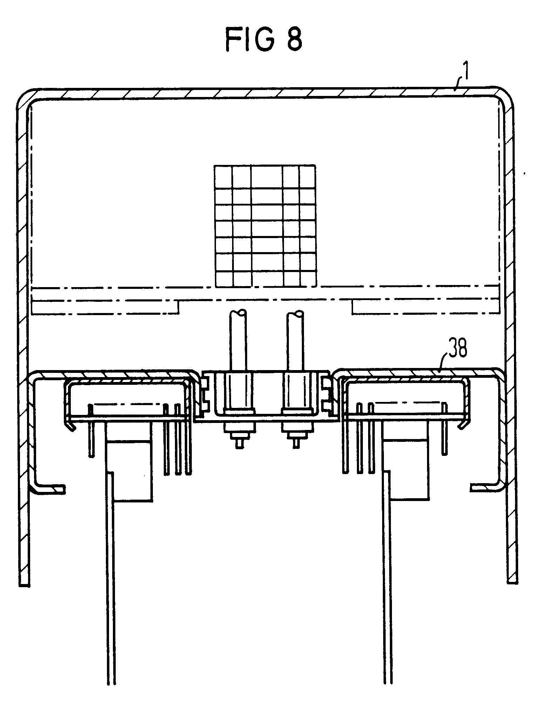

- Figur 8: zeigt schließlich ein Ausführungsbeispiel für den Gestellrahmen in Blechausführung.

Der eigentliche Gestellrahmen, der gleichzeitig eine Trag- und Abschirmfunktion erfüllt, besteht im wesentlichen aus einem U-förmigen Rahmen 1. Der Rahmen ist also nach hinten vollkommen abgeschlossen und einzelne Einsätze in Form von Buchsen 2 sind von vorne her ziemlich weit überlappend in diesen Rahmen eingesteckt und an den Stellen 18 mit dem Rahmen verschraubt.

Die einzelnen Buchsen sind zur Frontseite hin mit abnehmbaren hochfrequenzdichten Deckeln 3 verschlossen. In diesen Buchsen befinden sich nockenförmige Führungselemente 37 in die größere Leiterplatten 4 einsteckbar sind. Die rückseitig an der Platte befindlichen mehrreihigen Steckverbinderanschlüsse 5 sind in Gegensteckverbinder 6 einsteckbar. Die Platten 4 sind beispielsweise in Doppel-Eruopaformat ausgeführt und mit dreireihigen 96poligen Steckverbindern versehen. Vorzugsweise sind in einer Buchse rechts und links je eine solche Steckplatine angeordnet. Der Auszug wird durch hebelartige Auszugshilfen 31 erleichtert.

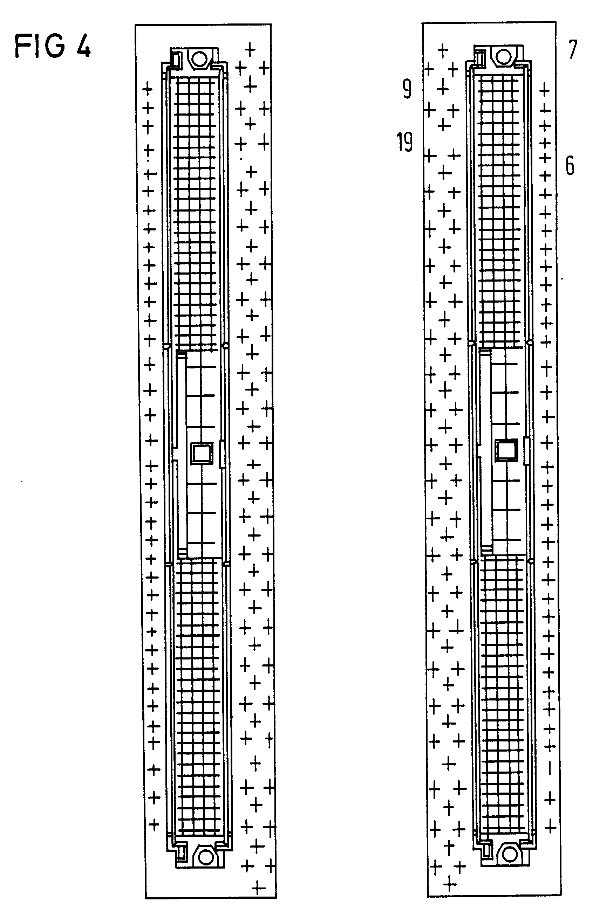

Da zu den einzelnen übereinander angeordneten Buchsen mit den Geräten viele, meist koaxiale Leitungen 34 zugeführt werden müssen, ist rückseitig im Gestellrahmen das heißt dem U-Profil ein größerer Raum hierfür vorgesehen. Wichtig ist es dabei, daß dieser Raum möglichst vollkommen von der vorderseitigen Geräteebene abgeschirmt wird. Zu diesem Zweck sind an der vorderen Begrenzung des Kabelsraumes 11 Trennwände 38 vorgesehen, die sich bis zu einem Abdeckblech 14, durch das die Kabel zu den einzelnen Geräten hindurchgeführt sind, von beiden Seiten des U-Profils her erstrecken. Es entstehen so eigentlich zwei einzelne Kabelräume 11 und um die entsprechenden Kabelbündel auseinanderzuhalten sind senkrecht untereinander mit Abstand Trennbleche 12 als U-förmige Blechbügel in den Gestellrahmen eingelegt. Die für die Einzelgeräte in den Buchsen 2 erforderlichen Amtskabel 13 sind gemeinsam auf eine längliche Abdeckung 14 geführt, die Durchführungen 16 für diese Leitungen hat. Diese Durchführungen sind bei Koaxialkabeln im einfachsten Falle runde Löcher, wobei es möglich ist, die Abschirmung im Randbereich dieser Löcher direkt mit dem Blech zu verlöten, oder wie in Figur 5 ersichtlich, einschraubbare Buchsen. Es ist auch möglich, die Kabel direkt hindurchzuführen und wie später erläutert mit Wrapstiften sowohl außen- als auch innenleiterseitig zu verbinden. Das Abdeckblech 14 hat die Längserstreckung einer Buchse und ist hochfrequenzdicht zum Beispiel mittels Dichtschnüren 17 mit den Rändern der Trennwände 38 verbunden. Es ist von vorne einlegbar und hinten durch eine nach oben offene und sich dorthin erweiternde Abschirmkappe 15 zusätzlich abgeschlossen. Die Verdrahtung erfolgt im Gestell zweckmäßig von unten nach oben, so daß das Leitungsbündel 34 langsam größer wird. In zusätzlichen Ausformungen der Trennwände 38 sind nun nach vorne hin streifenförmige Leiterplatten 7, die vorzugsweise als Multilayerplatten ausgebildet sind, geschirmt in diese Trennwände eingelassen. Diese Multilayerplatten tragen nach vorne hin die gestellseitigen Gegensteckverbinderreihen 6 und ihre Anschlußstifte sind über die Vielfachverbindungen der Multilayer mit Reihen von Wrapstiften 8 und 9 verbunden. Zweckmäßig ist es dabei für die Abschirmungen der durch die Platte 14 geführten Leitungen nächst der Mittellinie eine Wrapstiftreihe 19 vorzusehen, die direkt, zum Beispiel nagelförmig, mit den Trennwänden 38 des U-Profils verbunden ist. Auf die Wrapstiele 9 können dann die Innenleiter 30 der Koaxialleitungen aufgewrapt werden. Dies gilt auch für eventuell vorgesehene symmetrische Leitungen, die dann zweckmäßig durch Durchführungskondensatoren im Deckblech 14 geführt sind.

Eine außenseitig neben den Steckverbindernreihen 6 jeweils vorgesehene Wrapstiftreihe 8 dient zweckmäßig der Verbindung von intern unter den einzelnen Gehäusen zu führenden Leitungen 35 für die seitwärts neben den Multilayers 7 ein eigener Verdrahtungsraum 10 im U-Profil vorgesehen ist.

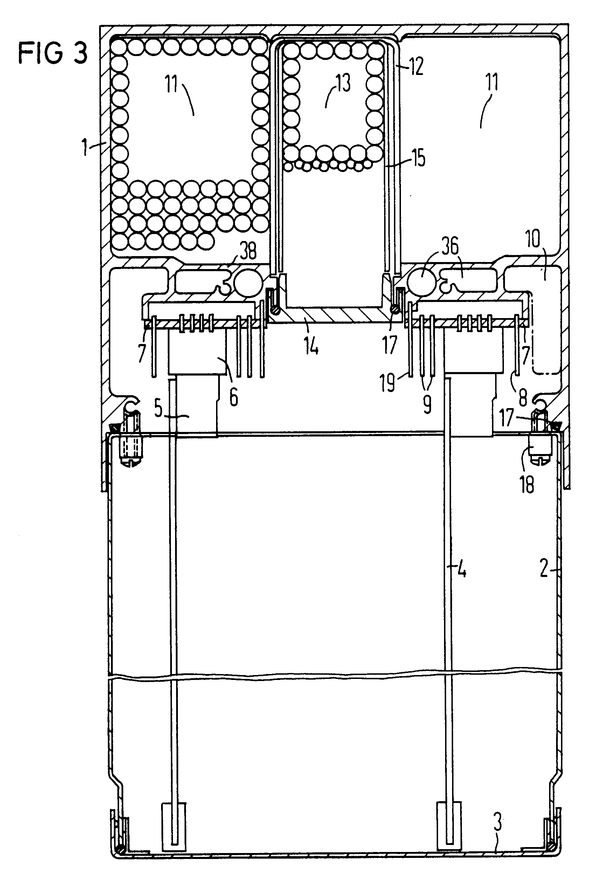

Zweckmäßig wird das U-Profil als Strangpreßprofil ausgeführt, so daß es auf einfache Weise gewährleistet ist, die einzelnen Kabelräume zu trennen und die Befestigungsmöglichkeiten für die einzelnen Platten Abdeckungen und Gehäuse (beispielsweise in Figur 3 dargestellt) zu integrieren. Dabei ist auch möglich, zusätzliche gegebenenfalls erforderliche Luftführungsschächte 36 im Profil mit vorzusehen.

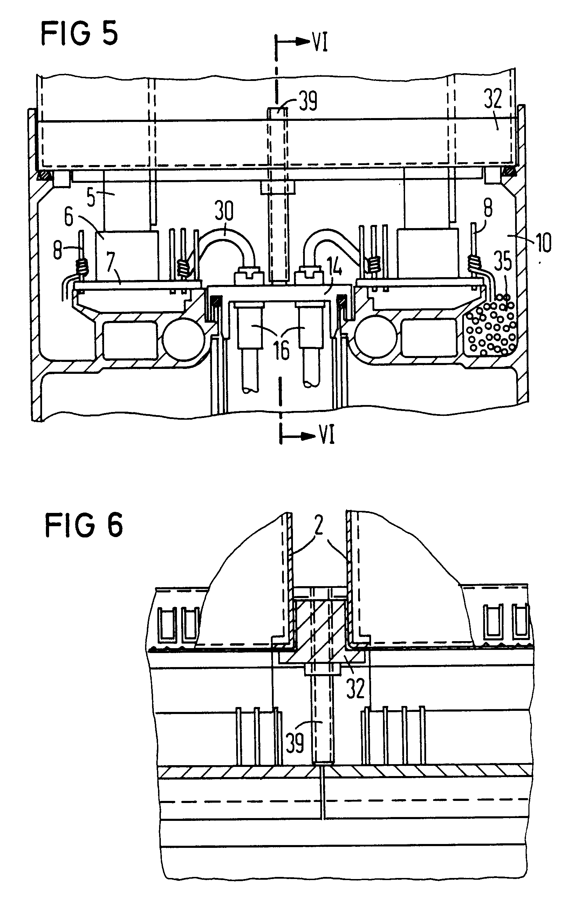

Da die einzelnen Buchsen senkrecht untereinander mit Abstand befestigt werden müssen, was auch für eventuelle Kühlluftzuführung zweckmäßig ist, sind zur Abshirmung der Zwischenräume traversenförmige Zwischenelemente 32 vorgesehen. Diese sind über Federdichtelemente oder hochfrequenzdichte Schnüre wiederum hochfrequenzdicht mit den U-Pofil bzw. den Gehäusen allseits kontaktiert. Diese in den Figuren 5 und 6 dargestellten Elemente greifen mit Nutprofilen unter die Buchsen und haben mittig Druckschrauben 39 mit denen die Abdeckungen festgepreßt werden.

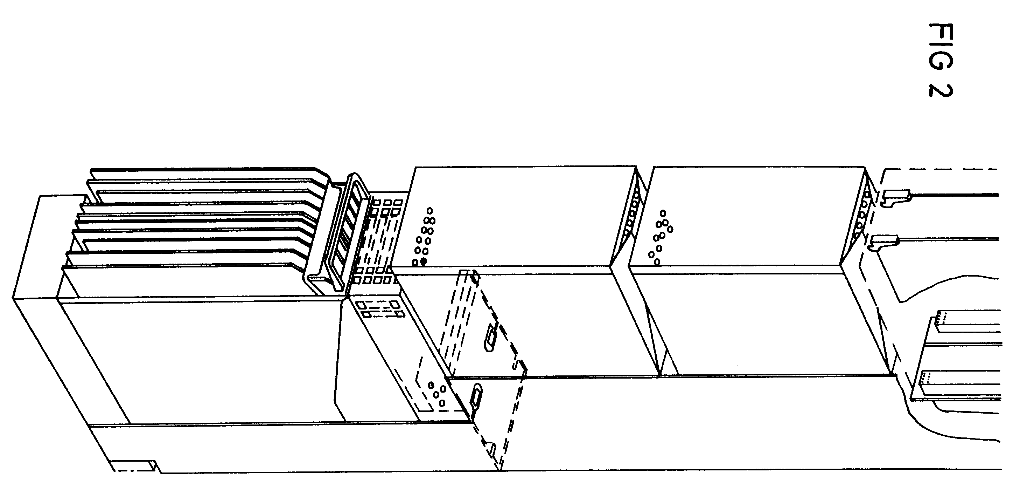

Wie aus der Figur 2 ersichtlich, ist auch eine gemischte Bestückung eines solchen Gestelles möglich, wie es in der bisherigen Bauweise 7 der Amtsbautechnik üblich ist. Hierzu ist in diesem Beispiel als unterer Abschluß ein mit Konsolblechen 21 versehenes Element 25 vorgesehen. Dieses Element schließt einerseits den internen Verdrahtungsraum 10 nach unten hin ab und hat dort beispielsweise auch Lüftungsöffnungen 26. Die internen Leitungen, die zum Beispiel der Stromversorgung und Signalisierung dienen sind über Duchführungskondensatoren 27 aus dem abgeschirmten Raum heraus geführt. Der U-förmige Gestellrahmen ist an der Stelle 24 abgesetzt, da er an dieser Stelle nicht mehr in dieser Tiefe erforderlich ist und die Montage erleichtert. Das Abschlußelement 25 hat nach vorne Luftzuführungsöffnungen 22 so daß Kühlluft in die in den Büchsen 2 vorgesehenen Öffnungen 23 eindringen kann. Die Kühlluft kann an der Oberseite eines solchen Einsatzes über Öffnungen entweichen und ist dort über ein dachförmiges Luftleitblech 29 nach vorne abgelenkt.

Im Konsol 21 kann ein normaler Gestelleinsatz, beispielsweise zur Stromversorgung, oder auch ein Leitungsendgerät eingesteckt werden. Die unterste Begrenzung des Gestells bildet ein Sockel 28.

Für den oberen Abschluß des internen Verdrahtungsraumes sorgt ein Element 33, das ebenfalls hochfrequenzdicht mit Kontaktfedern mit der obersten Buchsenbegrenzung und dem Gestell verbunden ist. Es kann Lüftungsbohrungen enthalten. Die Lüftungsbohrungen in den Buchsen und den Abschlüssen sind zweckmäßig so dimensioniert, daß ein Übertritt von Hochfrequenzenergie unmöglich ist.

Es ist auf diese Weise ein für den einangs genannten Zweck sehr vorteilhaftes, einfach zu montierendes und servicefreundliches Gestell gegeben.

## Patentansprüche

1. Gestell für die elektrische Nachrichtentechnik bei dem in vertikaler Richtung Einzelgeräte übereinander angeordnet sind, die über Steckanschlüsse (5) mit der Gestell- als auch der Amtsverdrahtung (34) verbunden sind,
**dadurch gekennzeichnet,**
daß der Gestellrahmen aus einer U-Profilschiene (1) besteht, in dem rückseitig Verdrahtungsräume (10, 11) für Gestell- als auch Amtsleitungen (34) vorgesehen sind und in die vorderseitig rahmenartige mit frontseitigem Deckel (3) verschließbare Buchsen (2) für die Geräte einsteckbar sind, und daß die Verdrahtungsräume gegenüber dem Raum für Geräte gegen Hochfrequenz dicht abgeschlossen sind und daß die Leitungen zu den übereinander angeordneten Buchsen durch mittig senkrecht angeordnete rechteckige Abdeckungen (14) geführt sind und beidseits der Abdeckungen in gegenüber den Verdrahtungsräumen (11) abgeschlossenen Räumen streifenförmige Leiterplatten (7), vorzugsweise Multilayerplatten, angeordnet sind, auf denen sich vertikal langgestreckte Vielfachsteckverbinder (5) befinden, neben denen mehrere (8, 9, 19) Reihen von mit den einzelnen Steckkontakten verbundenen Wrapstiften liegen, die einerseits auf die durch die Abdeckung geführten Amtsleitungen (33) und andererseits auf eine Internverdrahtung (35) führen, die in einem Internverdrahtungsraum (10) geführt sind und daß ferner in den Buchsen (2) geführte Steckplatinen (4) direkt auf die Vielfachsteckverbinder (5) aufgesteckt sind.

2. Gestell nach Anspruch 1,
**dadurch gekennzeichnet,**
daß der Gestellrahmen aus einem Strangpreßprofil besteht, das bereits die Kabelführungsräume (11), die Räume und Öffnungen für die Abdeckung (14), die Multilayer (7), die internen Verdrahtungsräume (10) und eventuell Luftführungsschächte (36) enthält.

3. Gestell nach Anspruch 1 oder 2,
**dadurch gekennzeichnet,**
daß die einzelnen Buchsen mit Zwischenraum übereinander angeordnet und mit dem Gestellrahmen (1) verschraubt (18) sind und dazwischen über traversenartige Zwischenelemente (32) und oben und unten über ähnliche Abschlußelemente (25, 33), die erforderlichenfalls Durchführungen mit Durchführungskondensatoren (27) für Versorgungs- und Signalleitungen enthalten, hochfrequenzdicht verbunden sind.

4. Gestell nach Anspruch 3,
**dadurch gekennzeichnet,**
daß die Buchsen (2) und die Zwischen- oder Abschlußelemente (25, 32, 33) kleinere Lochungen für Kühlluft haben und zwischen den Buchsen dachförmige Luftleitbleche (29) angeordnet sind.

5. Gestell nach einem der vorhergehenden Ansprüche,
**dadurch gekennzeichnet,**
daß zwischen den einzelnen gegeneinander und/oder nach außen abzuschirmenden Flächen der Buchsen (2), Zwischen- und Abschlußelemente (32, 33) und den Übergängen zum Gestellrahmen (1) federblechartige oder schnurförmige Hochfrequenzdichtungselemente (zum Beispiel 17) angeodnet sind.

6. Gestell nach einem der vorhergehenden Ansprüche,
**dadurch gekennzeichnet,**
daß die von der oberen Gestellbegrenzung her zugeführten Leitungsbündel (33) unterhalb der Abdeckung (14) mit den Durchführungen durch U-förmig gebogene Blechbügel (12) auseinandergehalten werden und die jeweiligen für die Verdrahtung zu den einzelnen Abdeckungen (14) erforderlichen Leitungen von unten nach oben eingefädelt und verdrahtet werden.

## Claims

1. Rack for electrical telecommunications, in the case of which individual apparatuses are arranged one above another in the vertical direction, which individual apparatuses are connected via plug connections (5) to the rack wiring and also to the exchange wiring (34), characterized in that the rack frame comprises a U-profiled rail (1) in which wiring spaces (10, 11) are provided on the rear side for both rack and exchange lines (34) and into which sockets (2), which are like a frame and can be closed by a cover (3) on the front side, for the apparatuses can be inserted on the front side, and in that the wiring spaces are closed in a radio-frequency-proof manner from the space for apparatuses, and in that the lines to the sockets which are arranged one above another are passed through centrally, vertically arranged rectangular covers (14), and strip-shaped printed-circuit boards (7), preferably multilayer boards, are arranged on both sides of the covers in spaces which are closed with respect to the wiring spaces (11), on which printed-circuit boards (7) vertically elongated multiple plug connectors (5) are located close to which a plurality (8, 9, 19) of rows of wrapping pins are located which are connected to the individual plug contacts, on the one hand lead to the exchange lines (33) which are passed through the cover, and on the other hand to internal wiring (35), and are guided in an internal wiring space (10), and in that, furthermore, plug-in boards (4) which are guided in the sockets (2) are plugged directly onto the multiple plug connectors (5).

2. Rack according to Claim 1, characterized in that the rack frame comprises an extruded profile which already contains the cable guiding spaces (11), the spaces and openings for the cover (14), the multilayer board (7), the internal wiring spaces (10) and, possibly, air-guidance shafts (36).

3. Rack according to Claim 1 or 2, characterized in that the individual sockets are arranged one above another with an intermediate space and are screwed (18) to the rack frame (1), and are connected in a radio-frequency-proof manner in between via crossbar-like intermediate elements (32) and above and below via similar closure elements (25, 33) which contain if necessary bushings with bushing capacitors (27) for supply lines and signal lines.

4. Rack according to Claim 3, characterized in that the sockets (2) and the intermediate elements or closure elements (25, 32, 33) have relatively small holes for cooling air, and roof-shaped air guide vanes (29) are arranged between the sockets.

5. Rack according to one of the preceding claims, characterized in that radio-frequency sealing elements (for example 17), which are like spring plates or are in the form of cords, are arranged between the individual surfaces of the sockets (2), which surfaces are to be screened with respect to one another and/or to the exterior, intermediate elements and closure elements (32, 33), and the transitions to the rack frame (1).

6. Rack according to one of the preceding claims, characterized in that the line harnesses (33) which are supplied from the upper rack boundary are held apart from one another underneath the cover (14) with the bushings by means of sheet-metal brackets (12) which are bent in a U-shape, and the respective lines which are required for the wiring to the individual covers (14) are threaded in and wired from the bottom to the top.

## Revendications

1. Bâti pour la technique électrique de transmission d'informations, dans lequel des appareils individuels, qui sont reliés par l'intermédiaire de bornes à enfichage (5) au câblage du bâti et au câblage (34) de liaison au central, sont superposés verticalement, caractérisé par le fait
que le cadre du bâti est constitué par un rail profilé en U (1), dans lequel sont prévus, sur le côté arrière, des espaces de câblage (10,11) pour les lignes raccordées au bâti ainsi que pour les lignes (34) de liaison au central et dans lequel des douilles (2) en forme de cadres, qui peuvent être fermées par un couvercle frontal (3), pour les appareils peuvent être enfichées sur le côté frontal, et que les espaces de câblage sont fermés de façon étanche vis-à-vis des hautes fréquences par rapport à l'espace servant à loger des appareils, et que les lignes aboutissant aux douilles superposées sont guidées dans des capots rectangulaires (14) disposés verticalement en position médiane, et que des deux côtés des capots sont disposées, dans des espaces fermés par rapport aux espaces de câblage (11), des plaquettes à circuits imprimés (7) en forme de bandes, de préférence des plaquettes à couches multiples, sur lesquelles sont situés des connecteurs multiples (5) dont la direction longitudinale est verticale et à côté desquels sont disposées plusieurs rangées (8,9,19) de bornes pour connexion enroulée, qui sont reliées aux différents contact à enfichage et aboutissent, d'une part, aux lignes (33) de liaison au central, qui traversent le capot, et, d'autre part, à un câblage interne (35) et sont guidées dans un espace de câblage (10) et qu'en outre des platines à enfichage (4) guidées dans les douilles (2) sont enfichées directement sur les connecteurs multiples (5).

2. Bâti suivant la revendication 1, caractérisé par le fait que le cadre du bâti est constitué par un profilé extrudé, qui présente déjà les espaces (11) de guidage des câbles, les espaces et les ouvertures pour le capot (14), les couches multiples (7), les espaces internes de câblage (10) et d'éventuelles conduits (36) de guidage de l'air.

3. Bâti suivant la revendication 1 ou 2, caractérisé par le fait que les différentes douilles sont superposées moyennant la présence d'un espace intercalaire et sont vissées (en 18) au cadre (1) du bâti et sont reliées, entre elles, d'une manière étanche aux fréquences, par l'intermédiaire d'éléments intercalaires en forme de traverses (32) et en partie haute et en partie basse par l'intermédiaire d'éléments terminaux semblables (25,33), qui présentent, le cas échéant, des traversées comportant des condensateurs de traversée (27) pour les lignes d'alimentation et les lignes de transmission de signaux.

4. Bâti suivant la revendication 3, caractérisé par le fait que les douilles (2) et les éléments intermédiaires ou les éléments terminaux (25,32,33) possèdent des trous plus petits pour l'air de refroidissement et que des chicanes en forme de toit (29) pour le guidage de l'air sont disposées entre les douilles.

5. Bâti suivant l'une des revendications précédentes, caractérisé par le fait que des éléments d'étanchéité aux hautes fréquences (par exemple 17) en forme de tôles élastiques ou de cordons sont disposés entre les différentes surfaces, qui doivent être protégées les unes par rapport aux autres et/ou en direction de l'extérieur, des douilles (2), des éléments intercalaires et des éléments terminaux (32,33) et les jonctions avec le cadre (1) du bâti.

6. Bâti suivant l'une des revendications précédentes, caractérisé par le fait que les faisceaux de conducteurs (33), qui atteignent la limite supérieure du bâti, sont maintenus écartés les uns des autres au-dessous du capot (14) pourvu des traversées, au moyen d'étriers en tôle (12) repliés en forme de U, et les lignes respectives, qui sont nécessaires pour le câblage aboutissant aux différents capots (14), sont enfilées et câblées de bas en haut.
